# EUROPEAN PATENT APPLICATION

(11) **EP 4 764 704 A2**
(43) Date of publication of application: **24.06.2026**
(21) Application number: 26169081.2
(22) Date of filing: 17.12.2021
(51) Int. Cl.: G03F 7/20

(54) **METHOD FOR EXPOSURE OF RELIEF PRECURSORS WITH MULTIPLE PROFILES**

(30) Priority: 17.12.2020 NL 2027142
(62) Divisional of application: 21840864.9
(71) Applicant: XSYS Germany GmbH, 77731 Willstatt (DE)
(72) Inventor: Thate, Maximilian, 71729 Erdmannhausen (DE); Beyer, Matthias, 69469 Weinheim (DE)
(74) Representative: Arnold & Siedsma

(57) **Abstract**

A method, a control means and an exposure apparatus for exposing a relief precursor (P) with a light source (2), the illumination area of the light source (2) covering part of the area of the precursor, wherein exposing the total area of the precursor is performed during an exposure pass by moving relatively to each other the light source and the precursor, the method comprising a step (20) of providing a mask (4) on a photosensitive layer, a first exposing step (ES 1) comprising exposing during one or more exposure passes the precursor according to a first intensity profile (IP1) and a first speed profile (SP1); a second exposing step (ES2) comprising exposing during one or more exposure passes the precursor according to a second intensity profile (IP2) different from the first intensity profile (IP1) and a second speed profile (SP2) different from the first speed profile (SP1).

## Description

### Field of invention

The field of the invention relates to apparatus and methods for exposure of relief precursors, in particular printing plate precursors.

### Background

Relief structures can be made by transfer of image information onto an imageable layer and removing parts of the imageable layer. The formed relief may then be used to transfer the information in a printing step onto a substrate. An example of a relief precursor is a printing plate precursor. Digitally imageable flexible printing plate precursors are known, and typically comprise at least a dimensionally stable support layer, a photosensitive layer and a digitally imageable mask layer. The digitally imageable mask layer may be e.g. a laser-ablatable layer. In case of conventional printing plate precursors, the digitally imageable mask layer is replaced by a separate mask which is attached to a photosensitive layer.

To produce a printing plate from a printing plate relief precursor, according to existing methods, first a mask is written into the digitally imageable layer based on image data to be printed. Following the writing of the mask, the plate is exposed through the mask with radiation such that the photosensitive layer undergoes polymerization or crosslinking or a reaction changing the solubility or fluidity of the photosensitive layer in the regions which are not covered by the mask. Following the exposure, the residues of the mask and of the non-exposed portions of the photosensitive layer are removed. This may be done with one or more liquids in a washer apparatus or by thermal development wherein non-exposed material of the photosensitive layer is liquefied by temperature increase and removed.

Exposure apparatus for printing plate precursors are known. An exposure apparatus may comprise a first light source for back exposure and a second light source for front exposure. Back exposure may be done using a set of UV light tubes. The back exposure creates a solid layer (floor) onto which the relief structures are generated. Front exposure may also be done using a set of UV light tubes or may be done using a movable UV light source, such as a movable laser or a LED bar or using stationary light source e.g. an arrangement of tubular light sources. Some exposure apparatus only do front exposure or only do back exposure, depending on the requirements. **In** some cases the exposure apparatus is capable to expose from both sides and embodiments of the invention relate to such cases.

As prior art are known US2018/0004093, US2018/0126721 and US2013/0242276 disclosing known methods for producing flexographic plates.

### Summary

The object of embodiments of the invention is to provide apparatus and methods to expose a relief precursor according to a plurality of profiles with an increased efficiency and/or printing quality.

According to a first aspect of the invention, a method is provided for exposing a relief precursor with a light source, the illumination area of the light source covering part of the area of the precursor, wherein exposing the total area of the precursor is performed during an exposure pass by moving relatively to each other the light source and the precursor. The method comprises a step of providing a mask on a photosensitive layer of the precursor, a first exposing step comprising exposing during one or more exposure passes the precursor through the mask according to a first intensity profile and a first speed profile and a second exposing step comprising exposing during one or more exposure passes the precursor through the mask according to a second intensity profile different from the first intensity profile and a second speed profile different from the first speed profile.

Thus, according to embodiments of the invention, both an intensity profile and a speed profile may be changed between two exposing steps. In this way, both the print quality and the power consumption may be controlled in a multi-variable manner depending on circumstances. Intensity and speed affecting both the printing quality and the efficiency (power consumption), a finer and more versatile control is achieved by controlling the first and the second exposing step according to different profiles for both intensity and speed. In this way, a wider range of relief precursors may produced while reaching for each the best printing quality at the best efficiency. Depending on the characteristics of the relief precursor (reactivity, thickness among others) to be exposed, typically one or more fast exposure passes at a high intensity may be followed by one or more slow exposure passes at a low intensity, to mitigate heat accumulation while achieving high curing quality.

According to a preferred embodiment, the first speed profile is such that the speed during the one or more exposure passes of the first exposing step is substantially constant and/or the second speed profile is such that the speed during the one or more exposure passes of the second exposing step is substantially constant. Alternatively at least one of the first or the second speed profile may be a variable profile over time, typically a profile with a decreasing or increasing speed over time. The profile may be varying either linearly or in steps. In this way, an even finer control of the exposing steps may be achieved.

According to a preferred embodiment, the average speed during an exposure pass of the first exposing step is higher than the average speed during an exposure pass of the second exposing step. In this way a fast exposing step precedes a slow exposing step. Typically a fast exposing step is associated with a first intensity while a slow exposing step is associated with a lower second intensity such in this way the relief precursor does not heat up too much while forming flat dots during the fast exposing step, while finishing curing during the slow exposing step. Alternatively the average speed during an exposure pass of the first exposing step may be lower than the average speed during an exposure pass of the second exposing. In this way, a slow exposing step precedes a fast exposing step. In this way, the fast final exposing step at a high intensity may also serve as post-exposure step, which would thus not have to be performed as a post-treatment. Omitting or reducing the post-treatment time is reducing the total development time of the relief precursor.

According to a preferred embodiment, the first intensity profile is such that the intensity during the one or more exposure passes of the first exposing step is substantially constant, and/or the second first intensity profile is such that the intensity during the one or more exposure passes of the second exposing step is substantially constant. Alternatively at least one of the first or the second intensity profiles may be a variable profile over time, typically a profile with a decreasing or increasing intensity over time. The profile may be varying either linearly or in steps. In this way, an even finer control of the exposing steps may be achieved.

According to a preferred embodiment, the average intensity during an exposure pass of the first exposing step is higher than the average intensity during an exposure pass of the second exposing step. In that case, a high intensity exposing step precedes a low(er) intensity exposing step. Typically a high intensity exposing step is associated with a fast speed while a low intensity exposing step is associated with a lower second speed. In this way the relief precursor forms flat dots and does not heat up too much during the high intensity exposing step, while finishing curing during the low intensity exposing step. Alternatively the first intensity may be lower than the second intensity. In that case, a low intensity exposing step precedes a high intensity exposing step. In this way, the fast final exposing step at a high intensity may also serve as post-exposure step, which would thus not have to be performed as a separate post-treatment. Omitting or reducing the post-treatment time is reducing the total development time of the relief precursor..

According to a preferred embodiment, the first exposing step comprises a first number of exposure passes, and/or the second exposing step comprises a second number of exposure passes. In this way, another variable for controlling the exposing steps is provided. By repeating exposure passes, the dose may be distributed between the passes to further control how the exposure of the relief precursor is to be performed to obtain the desired quality and efficiency.

According to a preferred embodiment, a first dose applied during a pass of the first exposing step is lower than a dose applied during a pass of the second exposing step. Preferably the first and second dose are between 0.2 to 30 J/cm² each. More preferably, the first dose is between 0,2 and 20 J/cm^{2,} preferably 0,5 to 18 J/cm², more preferably in the range of 1 to 17 J/cm² and the second dose is between 2 and 28 J/cm², preferably 5 to 25 J/cm², more preferably in the range of 10 and 20 J/cm².

According to a preferred embodiment, the first number of exposure passes is different from the second number of exposure passes. In this way, the different exposing behaviours according to the different profiles may be selectively repeated. Preferably the first number of exposure passes is higher than the second number of exposure passes. In this way the total dose can be spread between the exposure passes. More preferably, the first number of exposure passes is two or more and the second number of exposure passes is one.

According to a preferred embodiment, the light source is moved in exposure cycles with a first movement in a first direction and a second movement in a second opposite direction, and each exposure cycle comprises one or two exposure passes. In this way, exposure by the light source may be performed while moving in either one direction or both directions.

According to a preferred embodiment, the one or more first exposure passes of the first exposing step and the one or more exposure passes of the second exposing step are performed during movements in the same direction. Alternatively the one or more exposure passes of the first exposing step are performed during a movement in a first direction while the one or more exposure passes of the second exposing step are performed during a movement in a second opposite direction. Alternatively one or more exposure passes of the first exposing step and/or one or more exposure passes of the second exposing step are performed during movements in both directions. In this way, it is possible to expose in separate manners during the first and the second exposure steps and customize the exposure according to circumstances (thickness, reactivity among possible parameters to be taken into account)..

Preferably the average speed during an exposure pass of the first exposing step is in the range of 500 to 10000 mm/min, and the average speed during an exposure pass of the second exposing step is in the range of 10 to 1000 mm/min.

Preferably the average intensity during an exposure pass of the first exposing step is in the range of 30 to 10000 mW/cm², preferably 50 to 5000 mW/cm², more preferably in the range of 50 to 2500 mW/cm², and the average intensity during an exposure pass of the second exposing step is in the range of 1 to 5000 mW/cm², preferably 20 to 2500 mW/cm², more preferably in the range of 50 to 500 mW/cm², .

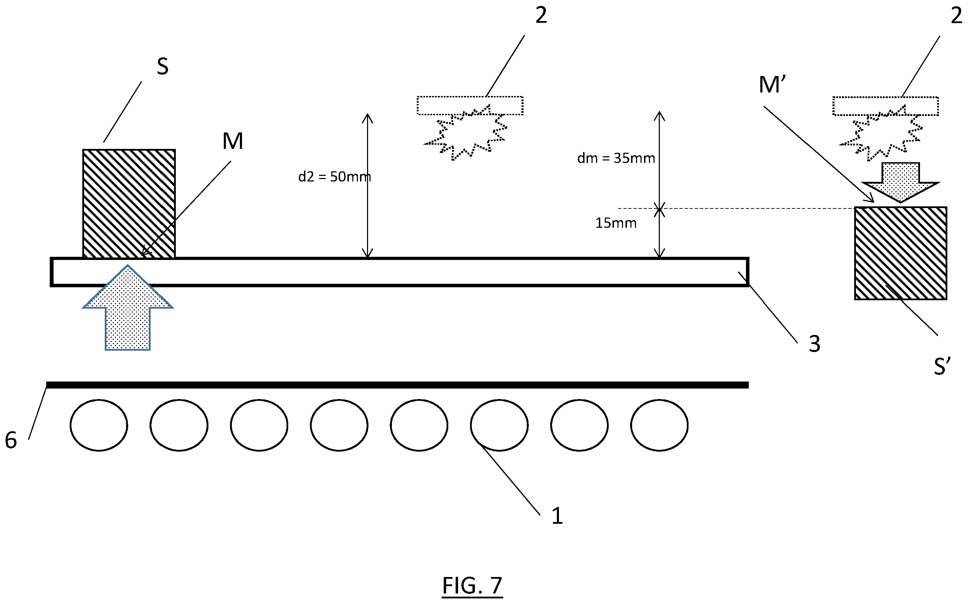

When referring to a first intensity or first intensity profile during one or more exposure passes of the first exposing step, it is intended to refer to an intensity measured by an Ophir 10A-V1.1 sensor with a 16 mm diameter diaphragm (Ophir Optronics Solutions Ltd) arranged so that the measuring side of the sensor in located in a plane corresponding with the first side of a relief precursor when the relief precursor is arranged in the exposure apparatus. Thus, when the exposure apparatus has a carrying structure with a support surface, e.g. a glass plate with a support surface, the sensor can be placed on the support surface with its measuring side oriented towards the first light source. This is illustrated in figure 7, where the sensor S is located on a support surface of a carrying structure 3, e.g. a glass plate, with the measuring side M of the sensor S arranged on the support surface such that the measuring side M receives the light emitted by the first light source.

When referring to a second intensity or second intensity profile during one or more exposure passes of the second exposing step, it is intended to refer to an intensity between the second light source and a plane corresponding with the first side of a relief precursor when the relief precursor is arranged in the exposure apparatus, at a distance of 15 mm from said plane. Thus, when the exposure apparatus comprises a carrying structure with a support surface, e.g. a glass plate, the intensity is the intensity at a distance of 15 mm above the support surface. However, because the sensor has a certain height and the distance between the second light source and the support surface is typically quite small, the light intensity may have to be measured outside of the exposure apparatus. Thus, the sensor may be arranged outside of the exposure apparatus, but such that the measuring side of the sensor is at a distance dm of the second light source which corresponds with a distance d2 between the second light source and the support surface minus 15 mm (dm = d2 - 15mm). Also the intensity of the second light source may be measured by an Ophir 10A-V1.1 sensor with a 16 mm diameter diaphragm (Ophir Optronics Solutions Ltd). This is illustrated in figure 7, where the sensor S' is located such that the measuring side M' of the sensor S' is at a distance dm of the second light source 2 which is equal to a distance d2 between the second light source 2 and the support surface of the carrying structure 3 (in the illustrated example d2 = 50mm) minus 15mm, i.e. dm = d2 - 15 mm = 50mm - 15mm = 35mm.

Preferably the ratio between the average speed during an exposure pass of the first exposing step and the average speed during an exposure pass of the second exposing step is higher than 1.5, preferably higher than 2, or wherein the ratio between the second and the first speed is higher than 0.05, preferably higher than 0.08.

Preferably the ratio between the average intensity during an exposure pass of the first exposing step and the average intensity during an exposure pass of the second exposing step is higher than 0.15, preferably higher than 0,5, more preferably higher than 1.0 or wherein the ratio between the second and the first intensity is higher than 0.5, preferably higher than 0.7, more preferably more than 1.

According to a preferred embodiment, a third exposing step is provided comprising exposing at a third speed and a third intensity, wherein the third speed is different from the second speed and/or the third intensity is different from the second intensity. In this way another exposing step for improving the quality may further be provided. Preferably the third exposing step may comprise one or more further steps.

According to a preferred embodiment, prior to the first and second exposing step, is provided a step for receiving the first intensity profile, the first speed profile, the second intensity profile and the second speed profile through a user input interface. In this way, the profiles may be customized by an operator.

According to a preferred embodiment, the step of providing a mask comprises the application of a pre-fabricated mask layer, or the generation of transparent areas in a mask layer which is an intrinsic layer of the precursor.

According to a preferred embodiment, the method further comprises back-exposing the precursor to electromagnetic radiation from a side of the precursor opposite to the relief forming side exposed before, after or during the first and second exposing step. Preferably the back-exposing is performed during the first and/or the second exposing step. More preferably, the method comprises based on the input first and second speed profile, whether or not to perform the step of back-exposing during the first and/or the second exposing step.

Preferably the wavelength of the electromagnetic radiation is in the range of 200 to 2000 nm.

According to a preferred embodiment, after the second exposing step further steps are preformed which are selected from the group comprising treatment with a liquid, treatment with a gas, thermal treatment, contacting with a surface, removal of material which may be dissolved or liquefied, exposure to electromagnetic radiation, exposure to a plasma, cutting, sanding or combinations thereof. In this way, post-treatment is realized.

Preferably the relief precursor comprises at least a dimensionally stable support layer, one or more photosensitive layers and optionally a cover layer, an adhesion layer, a barrier layer, a protection layer, a particle layer, a mask layer or combinations thereof.

According to another aspect of the invention, a relief structure is obtained by a method described in any one of the above preferred embodiments.

According to another aspect of the invention, there is provide the use of a relief structure according to the previous aspect as a flexographic printing plate, a letter press plate, a relief printing plate, a (flexible) printed circuit board, an electronic element, a microfluidic element, a micro reactor, a phoretic cell, a photonic crystal, an optical element or a Fresnel lens. To obtain a microfluidic element or a micro reactor an additional layer is added on top of the formed relief, thereby creating channels and spaces.

According to yet another aspect of the invention, is provided a control means configured for controlling the exposing of a relief precursor with a light source, the illumination area of the light source covering part of the area of the precursor, wherein exposing the total area of the precursor is performed during an exposure pass by moving relatively to each other the light source and the precursor. The control means are configured to control an intensity at a surface of the precursor and a movement speed of the light source, such that the following steps are performed: a first exposing step comprising exposing during one or more exposure passes the precursor through a mask according to a first intensity profile and a first speed profile; a second exposing step comprising exposing during one or more exposure passes the precursor through the mask according to a second intensity profile different from the first intensity profile and a second speed profile different from the first speed profile.

According to a preferred embodiment, the control means are configured to control a movement speed of the light source such that the speed the one or more exposure passes of the first exposing step is substantially constant and/or such that the speed during the one or more exposure passes of the second exposing step is substantially constant.

According to a preferred embodiment, the average speed during an exposure pass of the first exposing step is higher than the average speed during an exposure pass of the second exposing step.

According to a preferred embodiment, the control means are configured to control an intensity at a surface of the precursor such that the intensity during the one or more exposure passes of the first exposing step is substantially constant, and/or such that the intensity during the one or more exposure passes of the second exposing step is substantially constant.

According to a preferred embodiment, the average intensity during an exposure pass of the first exposing step is higher than the average intensity during an exposure pass of the second exposing step.

According to a preferred embodiment, the first exposing step comprises a first number of exposure passes, and/or wherein the second exposing step comprises a second number of exposure passes. Preferably the first number of passes is different from the second number of passes, wherein more preferably the first number of passes is higher than the second number of passes.

According to a preferred embodiment, a first dose applied during an exposure pass of the first exposing step is lower than a dose applied during an exposure pass of the second exposing step.

According to a preferred embodiment, the light source is moved in cycles with a first movement in a first direction and a second movement in a second opposite direction, and wherein each cycle comprises one or two exposure passes.

According to another aspect, an exposure apparatus is provided comprising a first light source configured to expose a first side of a relief precursor, a movable second light source configured to expose a second side of the relief precursor opposite the first side during one or more exposure passes, a moving means configured to move the second light source, and a control means according to any one of the above preferred embodiments.

The first light source, preferably a stationary light source, may comprise a plurality of LEDs or a plurality of light tubes, or a plurality of laser diodes or combinations thereof. Optionally the first light source may comprise an intensity control means configured for changing the intensity emitted by the first light source. For example, if the first light source is a LED array, the intensity control means may be a drive means configured to drive the LED array with different power levels. Alternatively, the intensity control means may be an optical means configured to vary the light intensity on the relief precursor, by placing for instance a partially absorbing, partially reflecting or partially diffracting medium between the light source and the relief precursor.

Also, the intensity may be changed by selecting a plate with suitable optical characteristics amongst a plurality of plates with different optical characteristics, and arranging this plate between the first light source and the relief precursor to influence the intensity seen by the relief precursor. This plate may be changed when a different intensity is required. In yet another example, a PCB with driver circuitry for generating a required drive current of the first light source may be selected amongst a plurality of PCBs configured for generating different drive current, depending on the required intensity. Also, the distance between the second light source and the relief precursor may be changed to influence the intensity seen by the relief precursor.

The second light source, preferably a movable light source, may comprise a plurality of LEDs or a plurality of light tubes, or a plurality of laser diodes or combinations thereof. Optionally the second light source may comprise a plurality of LEDs. In this way, a variable intensity may be achieved in a convenient manner. Optionally the second light source comprises an intensity control means configured for changing the intensity emitted by the second light source. For example, if the second light source is a LED array, the intensity control means may be a drive means configured to drive the LED array with different power levels. Alternatively, the intensity control means may be an optical means configured vary the light intensity on the relief precursor. Also, the intensity may be changed by selecting a plate with suitable optical characteristics amongst a plurality of plates with different optical characteristics, and arranging this plate between the second light source and the relief precursor to influence the intensity seen by the relief precursor. This plate may be changed when a different intensity is required. In yet another example, a PCB with driver circuitry for generating a required drive current of the second light source may be selected amongst a plurality of PCBs configured for generating different drive current, depending on the required intensity. Also, the distance between the second light source and the relief precursor may be changed to influence the intensity seen by the relief precursor.

According to a preferred embodiment, the exposure apparatus comprises a control means configured for back-exposing the precursor with electromagnetic radiation from a side of the precursor opposite to the relief forming side exposed before, after or during the first and second exposing step.

### Brief description of the figures

The accompanying drawings are used to illustrate presently preferred non limiting exemplary embodiments of the apparatus and method of the present invention. The above and other advantages of the features and objects of the invention will become more apparent and the invention will be better understood from the following detailed description when read in conjunction with the accompanying drawings, in which:
Figure 1 is a schematic sectional view of an exemplary embodiment of an apparatus for exposure of a relief precursor.
Figure 2 is a time diagram of the first exposing step of an exemplary embodiment of the method for exposure of a relief precursor cursor in a case where the second light source exposes only during a forward movement.
Figure 3 is a time diagram of the first exposing step of an exemplary embodiment of the method for exposure of a relief precursor cursor in a case where the second light source exposes during the whole cycle of forward and backward movement.
Figure 4 is a flowchart of an exemplary embodiment of the method for exposure of relief precursor.
Figure 5 is a table containing data according to exemplary embodiments of a method for exposure.
Figure 6 is a perspective view of another exemplary embodiment of an apparatus for exposure of a relief precursor.
Figure 7 illustrates schematically how the intensity emitted by the first and second light source is measured.

### Detailed description of embodiments

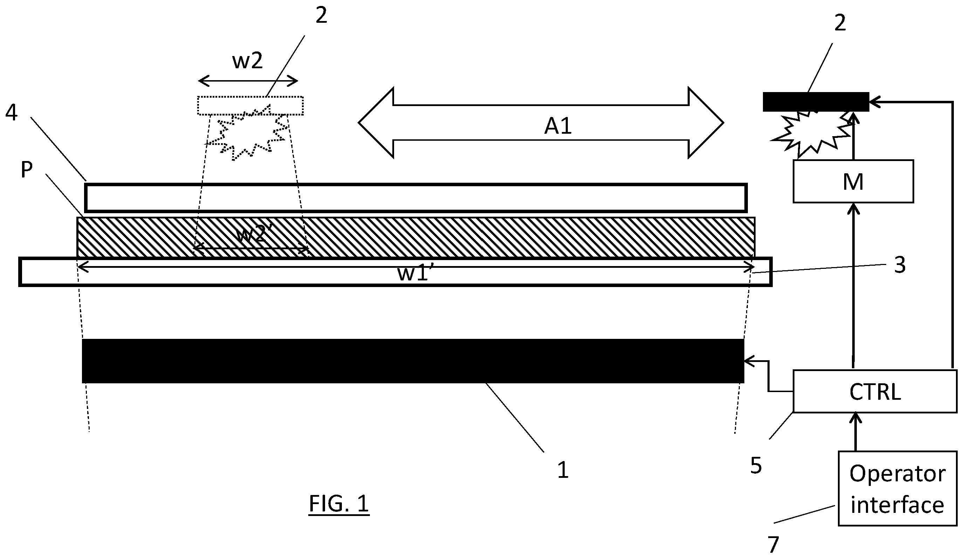

Figure 1 schematically illustrates a sectional view of an apparatus for exposure of a relief precursor P which comprises a substrate layer and at least one photosensitive layer. The apparatus comprises a first light source 1, a movable second light source 2, a carrying structure 3 and a mask 4 provided on the photosensitive layer of the relief precursor P. The first light source 1 is configured to illuminate a first side of the relief precursor P, here a lower side also called back side. The movable second light source 2 is configured to illuminate a second side of the relief precursor P, opposite the first side. The second side is typically a top side also called front side of the relief precursor P.

The first light source 1 substantially extends in a plane parallel to the relief precursor P. The first light source 1 is stationary. The second light source 2 is movable back and forward as indicated with arrow A1, in a plane parallel to the plane of the first light source 1.

Preferably, the first light source 1 is configured to illuminate a first illumination area of a plane (having a width w1' in figure 1) and the second light source is configured to illuminate a second illumination area of said plane (having a width w2' in figure 1), wherein said plane is located between the first light source and the second light source and corresponds with a plane in which the first side of the relief precursor P is intended to be located. The term illumination area of a plane is defined by the area where the intensity is higher than 10% of a maximum value of the light intensity in said plane. When a carrying structure 3 is present, the plane corresponds with a support surface of the carrying structure 3. Preferably, the second illumination area (having a width w2' in figure 1) is at least two times, more preferably at least three times, and most preferably at least five times smaller than the first illumination area (having a width w1' in figure 1). In typical embodiments, the first light source 1 is used to illuminate substantially the entire first side (i.e. the entire backside) of the relief precursor P, whilst the second light source 2 illuminates a smaller area of the second side (i.e. the upper side) of the relief precursor, typically with a higher light intensity. Preferably, the width w2' is between 100 mm and 600 mm, e.g. between 200 mm and 400 mm. Preferably, the width w1' is between 1500 mm and 3000 mm, e.g. between 1800 mm and 2500 mm.

The carrying structure 3, e.g. a glass plate, is configured for supporting the relief precursor, and is located between the second light source 2 and the first light source 1.The carrying structure 3 may be transparent to electromagnetic radiation emitted from the first light source 1.

The first light source 1 may be selected from the group comprising: a plurality of LEDs, a set of fluorescent lamps, a flash lamp, a set of light tubes, an LCD screen, a light projection system (with movable mirrors), a sun light collection system, and combinations thereof. The second light source 2 may be selected from the group comprising an LED array, a set of fluorescent lamps, a flash lamp, a set of light tubes arranged in a linear fashion, a (scanning) laser, an LCD screen, a light projection system (with movable mirrors), and combinations thereof.

Figure 1 illustrates a moving means M configured to move the second light source 2. The control means 5 may control the moving means M such that the second light source 2 exposes the whole surface of the relief precursor. The control means 5 may be configured for controlling the first light source 1 and for controlling and moving the second light source 2.

In particular the control means 5 may be configured to control the exposure by the second light source 2 to follow a received intensity profile and control the moving means M to move the second light source 2 according to a received speed profile. The control means 5 may receive intensity and speed profiles through the operator interface 7. The operator interface 7 may be a graphical interface.

The first light source, preferably a stationary light source, may comprise a plurality of LEDs or a plurality of light tubes, or a plurality of laser diodes or combinations thereof. Optionally the first light source may comprise an intensity control means configured for changing the intensity emitted by the first light source. For example, if the first light source is a LED array, the intensity control means may be a drive means configured to drive the LED array with different power levels. Alternatively, the intensity control means may be an optical means configured to vary the light intensity on the relief precursor, by placing for instance a partially absorbing, partially reflecting or partially diffracting medium between the light source and the relief precursor.

The second light source may comprise a plurality of LEDs. In this way, a variable intensity may be achieved by using as intensity control means a drive means configured to drive the LED array with different power levels. Alternatively, the intensity control means may be an optical means configured vary the light intensity on the relief precursor by placing for instance a partially absorbing, partially reflecting or partially diffracting medium between the light source and the relief precursor. In addition or alternatively, the intensity control means may control the movement of an additional plate disposed between the light source 2 and the relief precursor P to control the dose seen by the relief precursor P, and/or may control the distance between the second light source 2 and the relief precursor to control the intensity seen by the relief precursor P.

According to an embodiment, once a mask 4 is provided on a photosensitive layer of the relief precursor, the control means 5 may be configured to control the second light source 2 to follow a first intensity profile received through the operator interface 7 while controlling the moving means M to expose the relief precursor according to a first speed profile received through the operator interface 7. In this first exposing step, the relief precursor P may thus be exposed through the mask 4 according to a first intensity profile and a first speed profile. The control means may then be configured to expose the relief precursor according to a second exposing step, during which the precursor is exposed with the second light source 2 through the mask according to a second intensity profile different from the first intensity profile while the second light source 2 is moved by the moving means M according to a second speed profile different from the first speed profile.

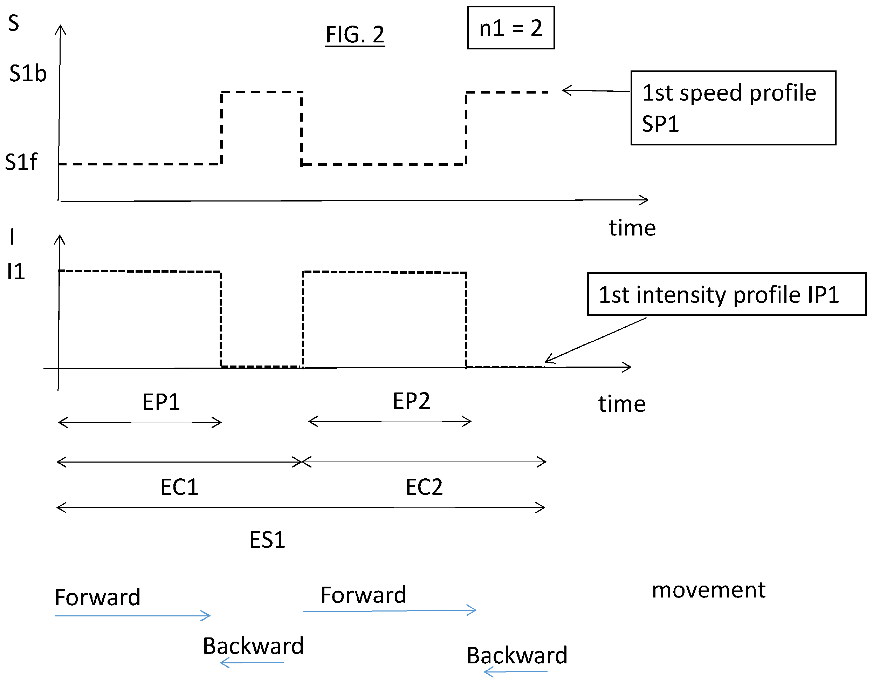

Figure 2 is a time diagram of the first exposing step of an exemplary embodiment of the method for exposure of a relief precursor cursor in a case where the second light source exposes only during a forward movement. The second light source 2 may then be moved in exposure cycles with a first movement in a first direction and a second movement in a second opposite direction. Each exposure cycle may comprise one exposure pass and one time period for bringing the light source back into its original position.

Figure 2 shows as an example a first exposing step ES1 comprising two cycles EC1 and EC2. During each cycle EC1, EC2, the light source may expose the relief precursor during an exposure pass EP1, EP2 while during the rest of the cycles the light source is brought back into its original position for the next cycle.

During the first exposing step ES 1, the intensity I of the second light source 2 is controlled to follow a first intensity profile IP1. The first intensity profile IP1 is such that, during the exposure passes EP1 and EP2, the intensity is substantially constant and equal to an average intensity I1 and during the rest of the cycles EC1 and EC2 substantially zero. Yet, depending on circumstances, other options could be envisaged where the first intensity profile IP1 would follow a profile increasing or decreasing with time during each pass of the first exposing step or between subsequent passes of the first exposing step. A stepwise or linear increase of intensity between passes of the first exposing step could also be envisaged.

During the first exposing step ES1, the speed of the moving means M moving the second light source 2 is controlled to follow a first speed profile SP1. The first speed profile SP1 is such that during the exposures passes EP1 and EP2 the speed is substantially constant and substantially equal to an average speed S1f for forward movement during the first exposing step while, during the rest of the cycles EC1 and EC2, the speed is substantially equal to an average speed S1b for backward movement during the first exposing step. The backward speed S1b is typically higher that the forward speed Sf to keep the duration of the backward movement as small as possible. Yet, depending on circumstances, other options could be envisaged where the first speed profile SP1 would follow a profile increasing or decreasing with time during each pass of the first exposing step or between subsequent passes of the first exposing step. A stepwise or linear increase of speed between passes of the first exposing step could also be envisaged. Additionally both speed and intensity could have a profile that could be customized according to circumstances.

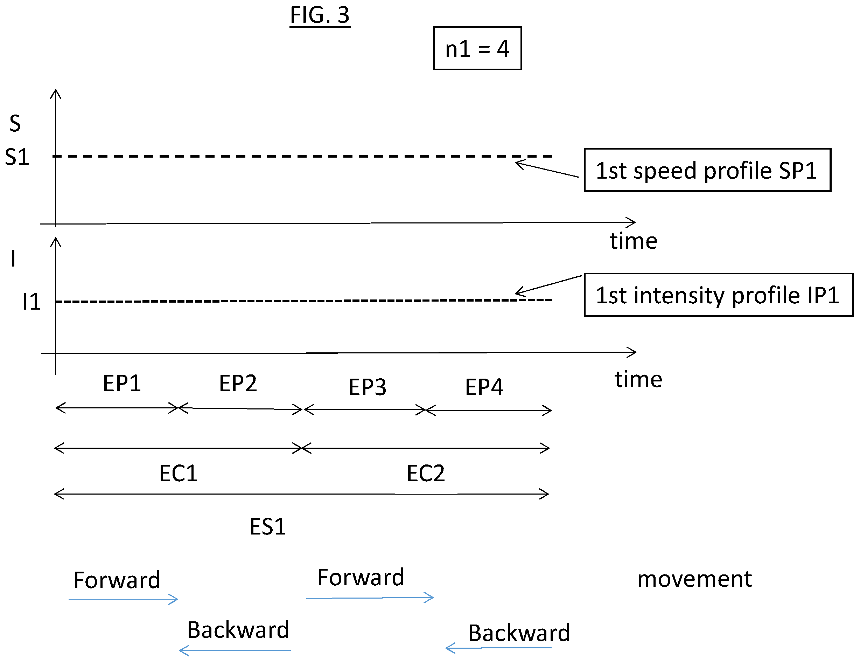

Figure 3 is a time diagram of the first exposing step of an exemplary embodiment of the method for exposure of a relief precursor cursor in a case where the second light source exposes during the whole cycle of forward and backward movement.

In Figure 3, the first exposing step ES1 comprises also two cycles EC1 and EC2. Yet contrary to the embodiment of Figure 2, in Figure 3, the second light source 2 may expose the relief precursor during a whole exposure cycle, meaning during both forward and backward movement of the second light source 2. Each cycle comprises in that case two exposure passes. For instance the cycle EC1 comprises the exposure passes EP1 and EP2, while the exposure cycle EC2 comprises the exposure passes EP3 and EP4, where during EP1 and EP3 the second light source 2 is moved in the same (forward) direction whereas during EP2 and EP3 the second light source 2 is moved in the opposite (backward) direction.

During the whole first exposing step ES1, the intensity I of the second light source 2 is controlled to follow a first intensity profile IP1 being a substantially constant average intensity I1. Similarly, during the whole first exposing step ES1, the speed of the moving means M moving the second light source 2 is controlled to follow a first speed profile SP1 being a substantially constant average speed S1 for both forward and backward movement.

Additionally, like for the embodiment of Figure 2, other options than constant profiles could be envisaged for the intensity profile or the speed profile or both depending on circumstances to customize the first exposing step to the needs of the operator. For instance the average speed and/or average intensity during the passes of the first exposing step could be increased stepwise after a certain number of passes.

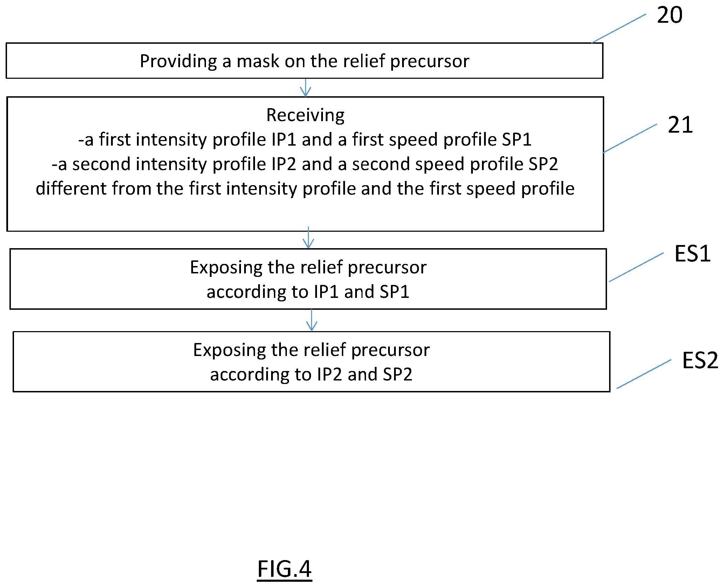

Figure 4 is a flowchart of an exemplary embodiment of the method for exposure of relief precursor.

In an initial step 20, a mask 4 may be provided on a photosensitive layer of the relief precursor P. Next in a step 21, a first intensity profile IP1, a first speed profile SP1, a second intensity profile IP2 and a second speed profile SP2 may be received through the operator interface 7. Next the relief precursor P may be, in a first exposing step ES1, exposed according to the first intensity profile IP1 and the first speed profile SP1 and, in a second exposing step ES2, exposed according to the second intensity profile IP2 and the second speed profile SP2.

In an exemplary embodiment, all the profiles may be constant. For instance the first intensity profile IP1 and the second intensity profile IP2 may be such that the average intensity I1 during an exposure pass of the first exposing step ES1 may be higher than the average intensity I2 during an exposure pass of the second exposing step ES2. Similarly the first speed profile SP1 and the second speed profile SP2 may be such that the average speed S1 during an exposure pass of the first exposing step ES1 may be higher than the average speed S2 during an exposure pass of the second exposing step ES2. However, as discussed already previously, other profiles for the intensity and/or the speed during the first and/or second exposing step may also be envisaged.

As defined in Figures 2 and 3, by pass is meant a movement in a single direction to cover the whole surface of the relief precursor with the illumination area of the second light source 2. Two consecutive passes in opposite directions may define a cycle. Each cycle may comprise one or two exposure passes. A cycle may indeed comprise a first pass in one direction during which exposure is performed and a second pass during which no exposure is performed and the second light source 2 is merely moved back into its initial position (like in Figure 2). Alternatively and preferably, a cycle may comprise two exposure passes, wherein exposure is performed during back and forth movement of the second light source 2 (like in Figure 3). In that context, the first exposing step ES1 may comprise a first number of passes n1 and/or the second exposing step ES2 may comprise a second number of passes n2. Typically the first and/or second number of passes, n1 and/or n2, may be received by the control means 5 through the operator interface 7. The first number of passes n1 may be typically higher than the second number of passes n2. The first dose applied during a pass of the first exposing step ES1 may also be typically lower than a dose applied during a pass of the second exposing step ES2.

Typically, the exposing method comprises a first exposing step ES1 comprising n1 relatively fast passes of the second light source 2 at a relatively high intensity I1 and a first relatively high speed S1 and a second exposing step ES2 comprising n2 relatively slow passes of the second light source 2 at a second relatively low intensity I2 and a second relatively low speed S2, with I1>I2 and S1>S2.

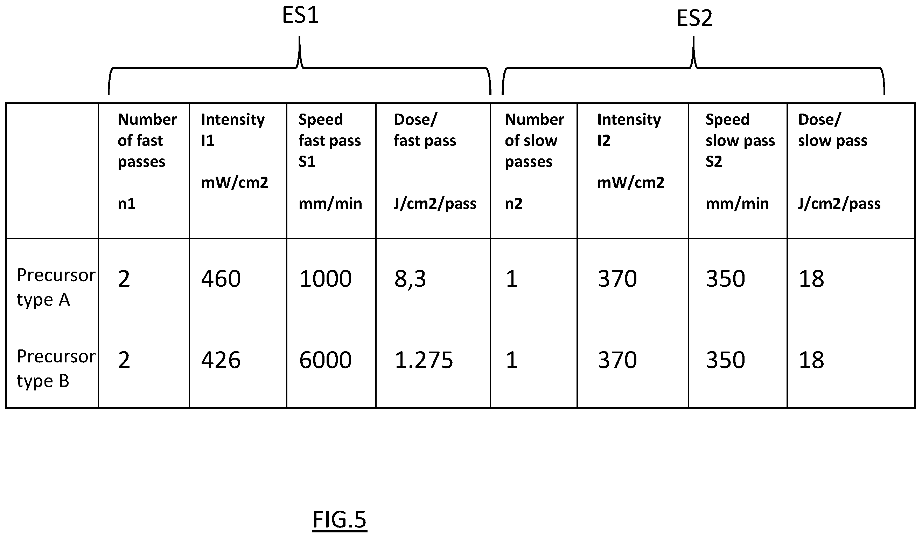

Figure 5 is a table containing data according to exemplary embodiments of a method for exposure. Two different relief precursors, labelled A and B, were exposed according to different first and second exposing steps. In these two examples the first exposing step ES1 comprised a plurality of fast passes during forward movement only while the second exposing step ES2 comprised one single slow pass (n2 was equal to one) during forward movement. Generally this sequence may be used to focus on first reducing oxygen inhibition in the relief precursor using high intensity to form flat dots during the first exposing step with fast passes while the second exposing step with a low pass at a low intensity may complete curing with moderate heating of the precursor.

It is noted that before, after or simultaneously with the first or second exposing step, the backexposure by the first light source 1 may be done. More generally, the timing and intensity of the exposing and moving steps by the first and second light source may be controlled in any possible manner, and may be adjusted e.g. in function of the type of relief precursor. For example, it is possible to adjust the timing such that whilst the first light source 1 exposes at a high power level, the second light source 2 is moved multiple times back and forth, so that each portion of the relief precursor has received the same dose at the end of the exposure by the first light source.

For a precursor of type A with a thickness of 1.14 mm, first two passes at 460 mW/cm² with the light source 2 were performed at a speed of 1000mm/min with a dose per pass of 8,3 J/cm², followed by one pass at 370 mW/cm² with the light source 2 with a speed of 350 mm/min and a dose of 18 J/cm²

For a precursor of type B with a thickness of 2.84 mm, first two passes at 426 mW/cm² with the light source 2 were performed at a speed of 6000mm/min with a dose per pass of 1,275 J/cm², followed by one pass at 370 mW/cm² with the light source 2 with a speed of 350 mm/min and a dose of 18 J/cm².

The print quality was rated as follows: when there was no difference in the ink density between the treated and untreated area on the paper it was denoted as poor quality. When the difference in the ink density between the treated and untreated area on the paper was strong and the two areas were separated by a clear border line it was denoted as high quality. Results in between were denoted as mediocre quality.

For both types of precursors, using the above exposing parameters, flat dots of high quality were obtained at high efficiency.

Yet alternative embodiments in which the first exposing step may comprise one or more slow passes and the second exposing step may comprise one or more fast passes may also be envisaged. In particular in such an embodiment, the second exposing step would expose at a high intensity which could be used to complete curing of the relief precursor. Completion of curing is generally a separate post-treatment step such that when combining completion of curing and the second exposing step a total development time may be reduced.

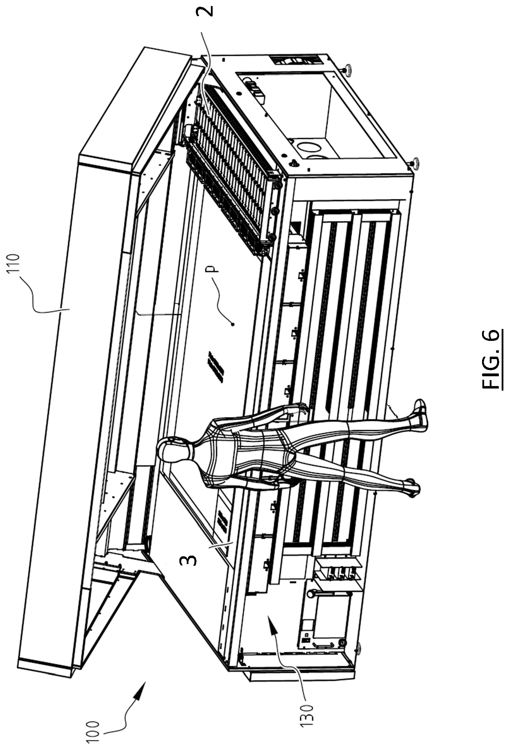

Figure 6 illustrates in detail an exemplary embodiment which uses the same main components as the embodiment of Figure 1, and those components will not be described again. The apparatus comprises a housing 100 with a lower housing portion 130 comprising the first light source and an upper housing portion 110 optionally comprising an additional light source. The relief precursor P may be manually or automatically brought onto a carrying structure 3, such that the relief precursor is located between the first light source in the lower housing portion 130 and the upper housing portion 110. The apparatus comprises a second light source 2 comprising a moveable LED bar. The movable LED bar structure 2 can be moved from right to left and back.

Further, in non-illustrated embodiments, a pre-treatment unit may be provided to perform a pre-treatment on the relief precursor, said pre-treatment being selected from the group comprising: cutting, ablation, exposure to electromagnetic radiation, and combinations thereof.

In non-illustrated embodiments, a post-treatment unit may be provided to perform a post-treatment on the relief precursor, e.g. washing, drying, post-exposure, heating, cooling, removing of material, etc. Further, in non-illustrated embodiments, a pre-treatment unit may be provided to perform a pre-treatment on the relief precursor, said pre-treatment being selected from the group comprising: cutting, ablation, exposure to electromagnetic radiation, and combinations thereof.

A relief precursor generally comprises a support layer and at least one photosensitive layer. The support layer may be a flexible metal, a natural or artificial polymer, paper or combinations thereof. Preferably the support layer is a flexible metal or polymer film or sheet. In case of a flexible metal, the support layer could comprise a thin film, a sieve like structure, a mesh like structure, a woven or non-woven structure or a combination thereof. Steel, copper, nickel or aluminium sheets are preferred and may be about 50 to 1000 µm thick. In case of a polymer film, the film is dimensionally stable but bendable and may be made for example from polyalkylenes, polyesters, polyethylene terephthalate, polybutylene terephthalate, polyamides und polycarbonates, polymers reinforced with woven, nonwoven or layered fibres (e.g. glass fibres, Carbon fibres, polymer fibres) or combinations thereof. Preferably polyethylene and polyester foils are used and their thickness may be in the range of about 100 to 300 µm, preferably in the range of 100 to 200 µm.

In addition to the photosensitive layer and the support layer, the relief precursor may comprise one or more further additional layers. For example, the further additional layer may be any one of the following: a direct engravable layer (e.g. by laser), a solvent or water developable layer, a thermally developable layer, a mask layer, a cover layer, a barrier layer, etc. Between the different layers described above one or more adhesion layers may be located which ensure proper adhesion of the different layers.

A relief precursor may carry at least one additional layer. For example, the additional layer may be any one of the following: a direct engravable layer (for example by laser), a solvent or water developable layer, a thermally developable layer, a photosensitive layer, a cover layer, a barrier layer, a combination of a photosensitive layer and a mask layer. Optionally there may be provided one or more further additional layers on top of additional layer. Between the different layers described above one or more adhesion layers may be located which ensure proper adhesion of the different layers. Such one or more further additional layers may comprise a cover layer at the top of all other layers which is removed before the imageable layer is imaged. The one or more additional layers may comprise a relief layer, and an anti-halation layer between the support layer and the relief layer or at a side of the support layer which is opposite of the relief layer. The one or more additional layers may comprise a relief layer, an imageable layer, and one or more barrier layers between the relief layer and the imageable layer which prevent diffusion of oxygen. Between the different layers described above one or more adhesion layers may be located which ensure proper adhesion of the different layers.

In a preferred embodiment the relief precursor comprises a support layer made of a polyester of polymer material, and an additional layer made of a directly engravable material such as a resin material. The optional layer may then be a laser ablative layer. In an exemplary embodiment the relief precursor may contain at least a dimensionally stable support layer, a relief layer and an imageable mask layer. Optionally, further layers may be present. There may be a cover layer at the top of all other layers which is removed before the imageable mask layer is imaged. There may be an anti-halation layer between the support layer and the relief layer or it may be located at the side of the support layer which is opposite of the relief layer. There may be one or more barrier layers between the relief layer and the imageable mask layer which prevent diffusion of oxygen. Between the different layers described above one or more adhesion layers may be located which ensure proper adhesion of the different layers. One or more layers may be removable by treatment with a liquid. The liquids used may be the same or different for different layers. Preferably the liquids used are different.

In a preferred embodiment the relief precursor comprises a photosensitive layer and a mask layer. The mask layer may be ablated or changed in transparency during the treatment and forms a mask with transparent and non-transparent areas. Preferably the mask layer and/or the barrier layer are removed in the pre-washing section of the system because they may comprise material which could cause problems in further process steps or during use of the final relief. Underneath of transparent areas of the mask the photosensitive layer undergoes a change in solubility and/or fluidity upon irradiation. The change is used to generate the relief by removing parts of the photosensitive layer in one or more subsequent steps. The change in solubility and/or fluidity may be achieved by photo-induced polymerization and/or crosslinking, rendering the irradiated areas less soluble. In other cases the electromagnetic radiation may cause breaking of bonds or cleavage of protective groups rendering the irradiated areas more soluble. Preferably a process using photo-induced crosslinking and/or polymerization is used.

Liquids which may be used to remove material from the exposed precursor include amongst others: Water, aqueous solutions, solvents and combinations thereof. The nature of the liquid used is guided by the nature of the precursor employed. If the layer to be removed is soluble, emulsifiable or dispersible in water or aqueous solutions, water or aqueous solutions might be used. If the layer is soluble, emulsifiable or dispersible in organic solvents or mixtures, organic solvents or mixtures may be used. In the case of organically developable precursors different organic solvents or their mixtures may be used.

Removal of uncured material from the exposed precursor may also be performed by heating and removal of liquefied material with a developing material. The removal of softened material is achieved by continuously contacting it with an absorbing material. The absorbing developer material may be a non-woven of polyamide, polyester, cellulose or inorganic fibres onto which the softened material is adhering and subsequently removed. Such methods are described for example in US 3,264,103, US 5,175,072, WO 96/14603 or WO 01/88615. Alternatively WO 01/90818 proposed to treat the exposed relief precursor with a hot gas or fluid jet to remove the non-cured material. In EP-A 469 735 and WO 01/18604 devices capable to perform the above mentioned methods are described.

Further embodiments of the invention are defined in the following clauses:
1. A method for exposing a relief precursor (P) with a light source (2), the illumination area of the light source (2) covering part of the area of the precursor, wherein exposing the total area of the precursor is performed during an exposure pass by moving relatively to each other the light source and the precursor, the method comprising:
   a step (20) of providing a mask (4) on a photosensitive layer of the precursor (P);
   a first exposing step (ES1) comprising exposing during one or more exposure passes the precursor through the mask according to a first intensity profile (IP1) and a first speed profile (SP1);
   a second exposing step (ES2) comprising exposing during one or more exposure passes the precursor through the mask according to a second intensity profile (IP2) different from the first intensity profile (IP1) and a second speed profile (SP2) different from the first speed profile (SP1).
2. The method according to any of the above clauses, wherein the first speed profile (SP1) is such that the speed during the one or more exposure passes of the first exposing step (ES1) is substantially constant and/or wherein the second speed profile (SP2) is such that the speed during the one or more exposure passes of the second exposing step (ES2) is substantially constant.
3. The method according to any of the above clauses, wherein the average speed (S1) during an exposure pass of the first exposing step (ES1) is higher than the average speed (S2) during an exposure pass of the second exposing step (ES2).
4. The method according to any of the above clauses, wherein the first intensity profile (IP1), is such that the intensity during the one or more exposure passes of the first exposing step (ES1) is substantially constant, and/or wherein the second first intensity profile (IP2) is such that the intensity during the one or more exposure passes of the second exposing step (ES2) is substantially constant.
5. The method according to any of the above clauses, wherein the average intensity (I1) during an exposure pass of the first exposing step (ES1) is higher than the average intensity (I2) during an exposure pass of the second exposing step (ES2).
6. The method according to any of the above clauses, wherein the first exposing step (ES1) comprises a first number of exposure passes (n1), and/or wherein the second exposing step (ES2) comprises a second number of exposure passes (n2).
7. The method according to any of the above clauses, wherein a first dose applied during an exposure pass of the first exposing step (ES1) is lower than a dose applied during an exposure pass of the second exposing step (ES2).
8. The method according to the previous clause, wherein the first and second dose are between 0.2 to 30 J/cm2 each.
9. The method according to the previous clause, wherein the first dose is between 0,2 and 20 J/cm2 and the second dose is between 2 and 28 J/cm2.
10. The method according to any one of the clauses 6-9, wherein the first number of exposure passes (n1) is different from the second number of exposure passes (n2).
11. The method according to any one of the clauses 6-10, wherein the first number of exposure passes (n1) is higher than the second number of exposure passes (n2).
12. The method according to any one of the clauses 6-11, wherein the first number of exposure passes (n1) is two or more and wherein the second number of exposure passes (n2) is one.
13. The method according to any one of the above clauses , wherein the light source (2) is moved in exposure cycles with a first movement in a first direction and a second movement in a second opposite direction, and wherein each exposure cycle comprises one or two exposure passes.
14. The method according to any of the above clauses, wherein the one or more first exposure passes of the first exposing step and one or more exposure passes of the second exposing step are performed during movements in the same direction.
15. The method according to any of the above clauses, wherein one or more exposure passes of the first exposing step and/or one or more exposure passes of the second exposing step are performed during movements in both directions.
16. The method according to any of the above clauses, wherein a first average speed (S1) during an exposure pass of the first exposing step is in the range of 1000 to 10000 mm/min, and the average speed (S2) during an exposure pass of the second exposing step is in the range of 10 to 1000 mm/min.
17. The method according to any of the above clauses, wherein the average intensity (I1) during an exposure pass of the first exposing step is in the range of 30 to 10000 mW/cm2, and the average intensity (I2) during an exposure pass of the second exposing step is in the range of 1 to 5000 mW/cm2.
18. The method according to any of the above clauses, wherein the ratio between the average speed (S1) during an exposure pass of the first exposing step and the average speed (S2) during an exposure pass of the second exposing step is higher than 1.5 preferably higher than 2, or wherein the ratio between the second and the first average speed is higher than 0,05 preferably higher than 0,08.
19. The method according to any of the above clauses, wherein the ratio between the average intensity (I1) during an exposure pass of the first exposing step and the average intensity (I2) during an exposure pass of the second exposing step is higher than 0.15, preferably higher than 0.5, more preferably higher than 1 or wherein the ratio between the second and the first average intensity is higher than 0,5, preferably higher than 0.7, more preferably higher than 1.
20. The method according to any of the above clauses, further comprising a third exposing step comprising exposing at a third speed and a third intensity, wherein the third speed is different from the second speed and/or the third intensity is different from the second intensity.
21. The method according to any of the above clauses, further comprising prior to the first (ES1) and second exposing step (ES2), receiving (21) the first intensity profile (IP1), the first speed profile (SP1), the second intensity profile (IP2) and the second speed profile (SP2) through an operator interface (7).
22. The method according to any of the above clauses, wherein the step (20) of providing a mask (4) comprises the application of a pre-fabricated mask layer, or the generation of transparent areas in a mask layer which is an intrinsic layer of the precursor.
23. The method according to any of the above clauses, further comprising back-exposing the precursor to electromagnetic radiation from a side of the precursor opposite to the relief forming side exposed before, after or during the first and second exposing step.
24. The method according to the previous clause, wherein the back-exposing is performed during the first (ES1) and/or the second exposing step (ES2).
25. The method of clause 19 and 21, further comprising, based on the input first and second speed profile (SP1,SP2), whether or not to perform the step of back-exposing during the first and/or the second exposing step (ES1, ES2).
26. The method according to any one of the clauses 23-25, wherein the wavelength of the electromagnetic radiation is in the range of 200 to 2000 nm.
27. The method according to any of the above clauses, wherein after the second exposing step (ES2) further steps are preformed which are selected from the group comprising treatment with a liquid, treatment with a gas, thermal treatment, contacting with a surface, removal of material which may be dissolved or liquefied, exposure to electromagnetic radiation, exposure to a plasma, cutting, sanding or combinations thereof.
28. The method according to any of the above clauses, wherein the relief precursor (P) comprises at least a dimensionally stable support layer, one or more photosensitive layers and optionally a cover layer, an adhesion layer, a barrier layer, a protection layer, a particle layer, a mask layer or combinations thereof.
29. A relief structure obtained by a method described in any one of the above clauses.
30. A use of a relief structure according to the previous clause as a flexographic printing plate, a letter press plate, a relief printing plate, a (flexible) printed circuit board, an electronic element, a microfluidic element, a micro reactor, a phoretic cell, a photonic crystal, an optical element or a Fresnel lens.
31. A control means (5) configured for controlling the exposing of a relief precursor (P) with a light source (2), the illumination area of the light source (2) covering part of the area of the precursor, wherein exposing the total area of the precursor is performed during an exposure pass by moving relatively to each other the light source and the precursor, the control means (5) being configured to control an intensity at a surface of the precursor and a movement speed of the light source (2), such that the following steps are performed:
   a first exposing step (ES1) comprising exposing during one or more exposure passes the precursor through a mask (4) according to a first intensity profile (IP1) and a first speed profile (SP1);
   a second exposing step (ES2) comprising exposing during one or more exposure passes the precursor through the mask (4) according to a second intensity profile (IP2) different from the first intensity profile (IP1) and a second speed profile (SP2) different from the first speed profile (SP1).
32. The control means according to clause 31, configured to control a movement speed of the light source (2) such that the speed the one or more exposure passes of the first exposing step is substantially constant and/or such that the speed during the one or more exposure passes of the second exposing step is substantially constant.
33. The control means according to any one of clauses 31-32, wherein the average speed (S1) during an exposure pass of the first exposing step is higher than the average speed (S2) during an exposure pass of the second exposing step.
34. The control means according to any one of clauses 31-33, configured to control an intensity at a surface of the precursor such that the intensity during the one or more exposure passes of the first exposing step is substantially constant, and/or such that the intensity during the one or more exposure passes of the second exposing step is substantially constant.
35. The control means according to any one of clauses 31-34, wherein the average intensity (I1) during an exposure pass of the first exposing step is higher than the average intensity (I2) during an exposure pass of the second exposing step.
36. The control means according to any one of clauses 31-35, wherein the first exposing step comprises a first number of exposure passes, and/or wherein the second exposing step comprises a second number of exposure passes, wherein preferably the first number of passes is different from the second number of passes, wherein more preferably the first number of passes is higher than the second number of passes.
37. The control means according to any one of the clauses 31-36, wherein a first dose applied during an exposure pass of the first exposing step is lower than a dose applied during an exposure pass of the second exposing step.
38. The control means according to any one of the above clauses 31-37, wherein the light source is moved in cycles with a first movement in a first direction and a second movement in a second opposite direction, and wherein each cycle comprises one or two exposure passes.
39. An exposure apparatus comprising a first light source (1) configured to expose a first side of a relief precursor, a movable second light source (2) configured to expose a second side of the relief precursor opposite the first side during one or more exposure passes, a moving means configured to move the second light source, and a control means according to any one of the clauses 31-38.
40. The exposure apparatus according to clause 39, wherein the control means is configured for back-exposing the precursor to electromagnetic radiation from a side of the precursor opposite to the relief forming side exposed before, after or during the first and second exposing step.

Whilst the principles of the invention have been set out above in connection with specific embodiments, it is to be understood that this description is merely made by way of example and not as a limitation of the scope of protection which is determined by the appended claims.

## Claims

1. A method for exposing a relief precursor (P) with a light source (2), the illumination area of the light source (2) covering part of the area of the precursor, wherein exposing the total area of the precursor is performed during an exposure pass by moving relatively to each other the light source and the precursor, the method comprising:
- a step (20) of providing a mask (4) on a photosensitive layer of the precursor (P);
- a first exposing step (ES1) comprising exposing during one or more exposure passes the precursor through the mask according to a first intensity profile (IP1) and a first speed profile (SP1);
- a second exposing step (ES2) comprising exposing during one or more exposure passes the precursor through the mask according to a second intensity profile (IP2) different from the first intensity profile (IP1) and a second speed profile (SP2) different from the first speed profile (SP1);
- wherein an average speed (S1) during an exposure pass of the first exposing step (ES1) is higher than an average speed (S2) during an exposure pass of the second exposing step (ES2); or wherein an average speed during an exposure pass of the first exposing step is lower than an average speed during an exposure pass of the second exposing.

2. The method according to claim 1, wherein the first speed profile (SP1) is such that the speed during the one or more exposure passes of the first exposing step (ES1) is substantially constant and/or wherein the second speed profile (SP2) is such that the speed during the one or more exposure passes of the second exposing step (ES2) is substantially constant.

3. The method according to any of the above claims, wherein the first intensity profile (IP1), is such that the intensity during the one or more exposure passes of the first exposing step (ES1) is substantially constant, and/or wherein the second first intensity profile (IP2) is such that the intensity during the one or more exposure passes of the second exposing step (ES2) is substantially constant.

4. The method according to any of the above claims, wherein an average speed (S1) during an exposure pass of the first exposing step (ES1) is higher than an average speed (S2) during an exposure pass of the second exposing step (ES2); and wherein the average intensity (I1) during an exposure pass of the first exposing step (ES1) is higher than the average intensity (I2) during an exposure pass of the second exposing step (ES2).

5. The method according to any of the above claims, wherein the first exposing step (ES1) comprises a first number of exposure passes (n1), and/or wherein the second exposing step (ES2) comprises a second number of exposure passes (n2);
wherein the first number of exposure passes (n1) is higher than the second number of exposure passes (n2); or
wherein the first number of exposure passes (n1) is two or more and wherein the second number of exposure passes (n2) is one.

6. The method according to any of the above claims, wherein the average speed (S1) during an exposure pass of the first exposing step is in the range of 1000 to 10000 mm/min, and the average speed (S2) during an exposure pass of the second exposing step is in the range of 10 to 1000 mm/min.

7. The method according to any of the above claims, wherein the ratio between the average speed (S1) during an exposure pass of the first exposing step and the average speed (S2) during an exposure pass of the second exposing step is higher than 1.5 preferably higher than 2, or wherein the ratio between the second and the first average speed is higher than 0,05 preferably higher than 0,08.

8. The method according to any of the above claims, wherein the ratio between the average intensity (I1) during an exposure pass of the first exposing step and the average intensity (I2) during an exposure pass of the second exposing step is higher than 0.15, preferably higher than 0.5, more preferably higher than 1 or wherein the ratio between the second and the first average intensity is higher than 0,5, preferably higher than 0.7, more preferably higher than 1.

9. The method according to any of the above claims, further comprising prior to the first (ES1) and second exposing step (ES2), receiving (21) the first intensity profile (IP1), the first speed profile (SP1), the second intensity profile (IP2) and the second speed profile (SP2) through an operator interface (7);
further comprising back-exposing the precursor to electromagnetic radiation from a side of the precursor opposite to the relief forming side exposed before, after or during the first and second exposing step;
wherein, based on the input first and second speed profile (SP1,SP2), it is determined whether or not to perform the step of back-exposing during the first and/or the second exposing step (ES1, ES2).

10. A control means (5) configured for controlling the exposing of a relief precursor (P) with a light source (2), the illumination area of the light source (2) covering part of the area of the precursor, wherein exposing the total area of the precursor is performed during an exposure pass by moving relatively to each other the light source and the precursor, the control means (5) being configured to control an intensity at a surface of the precursor and a movement speed of the light source (2), such that the following steps are performed:
- a first exposing step (ES1) comprising exposing during one or more exposure passes the precursor through a mask (4) according to a first intensity profile (IP1) and a first speed profile (SP1);
- a second exposing step (ES2) comprising exposing during one or more exposure passes the precursor through the mask (4) according to a second intensity profile (IP2) different from the first intensity profile (IP1) and a second speed profile (SP2) different from the first speed profile (SP1);
- wherein an average speed (S1) during an exposure pass of the first exposing step is higher than an average speed (S2) during an exposure pass of the second exposing step; or wherein an average speed during an exposure pass of the first exposing step is lower than an average speed during an exposure pass of the second exposing.

11. The control means according to claim 10, configured to control a movement speed of the light source (2) such that the speed the one or more exposure passes of the first exposing step is substantially constant and/or such that the speed during the one or more exposure passes of the second exposing step is substantially constant.

12. The control means according to claim 10 or 11, wherein an average speed (S1) during an exposure pass of the first exposing step is higher than an average speed (S2) during an exposure pass of the second exposing step, and wherein the average intensity (I1) during an exposure pass of the first exposing step is higher than the average intensity (I2) during an exposure pass of the second exposing step.

13. The control means according to any one of claims 10-12, wherein the first exposing step comprises a first number of exposure passes, and/or wherein the second exposing step comprises a second number of exposure passes, wherein preferably the first number of passes is different from the second number of passes, wherein more preferably the first number of passes is higher than the second number of passes.

14. The control means according to any one of the claims 10-13, wherein a first dose applied during an exposure pass of the first exposing step is lower than a dose applied during an exposure pass of the second exposing step.

15. An exposure apparatus comprising a first light source (1) configured to expose a first side of a relief precursor, a movable second light source (2) configured to expose a second side of the relief precursor opposite the first side during one or more exposure passes, a moving means configured to move the second light source, and a control means according to any one of the claims 10-14;
wherein optionally the control means is configured for back-exposing the precursor to electromagnetic radiation from a side of the precursor opposite to the relief forming side exposed before, after or during the first and second exposing step.
